# EUROPEAN PATENT SPECIFICATION

(11) **EP 1 111 775 B1**
(45) Date of publication and mention of the grant of the patent: **14.06.2006**
(21) Application number: 99500245.8
(22) Date of filing: 20.12.1999
(51) Int. Cl.: H03F 3/30, H03F 1/30

(54) **Power stage**
Leistungsstufe
Etage de puissance

(43) Date of publication of application: 27.06.2001
(73) Proprietor: Ecler Laboratorio de Electro Acustica S.A., 08038 Barcelona (ES)
(72) Inventor: Sanuy, Angel, 08038 Barcelona (ES)
(74) Representative: Gislon, Gabriele

(56) References cited:
- WO-A-97/25775
- GB-A- 2 157 104
- US-A- 4 464 634
- HEGGLUN I: "FAST POWER AMPLIFIER FOR AUDIO" ELECTRONICS WORLD AND WIRELESS WORLD,GB,REED BUSINESS PUBLISHING, SUTTON, SURREY, vol. 101, no. 1708, 1 March 1995 (1995-03-01), page 240 XP000506844 ISSN: 0959-8332
- STOCHINO G: "AUDIO DESIGN LEAPS FORWARD?" ELECTRONICS WORLD AND WIRELESS WORLD,GB,REED BUSINESS PUBLISHING, SUTTON, SURREY, vol. 100, no. 1703, 1 October 1994 (1994-10-01), pages 818-820,822,82, XP000474881 ISSN: 0959-8332

## Description

The object of this invention as indicated in the statement of this descriptive report consists of a "POWER STAGE" of the type used which uses switching MOSFETs, specifically conceived for audio applications requiring high output voltages (100 Vrms).

The principal innovation of this system is that it permits amplifications of 100 V. lines without the use of step-up transformers and makes the use of switching MOSFETs possible in high power audio amplifiers.

A power stage is understood as an electronic circuit capable of amplifying small electric signals (1 Vrms) to the voltage and power levels required by the application for which it is intended. This invention is applicable to audio systems requiring high output voltages for both small power levels (30 W for public address systems and ambient sound systems) and large power levels (30000 W for professional PA amplifiers used in night-clubs and concert halls).

Power stages are basically composed of amplifying circuits and protection circuits.

The amplifying circuit multiplies the voltage and power of the incoming signal up to the desired levels and the protection circuit preserves the amplifying unit and the elements excited by it (the speakers) against circumstances which could be harmful to either one of the two.

An amplifying circuit which provides output voltage of around 100 Vrms must have a power source of at least ±150 VCD, which subjects MOSFETS to maximum voltages of 300 V in the final step.

The principal technological limitation to making such a circuit using switching MOSFETs by means of an entirely conventional structure for the final step, i.e. with N and P channel MOSFETs) is the non-existence of P channel MOSFETs which can support voltages higher than 1000 V. The amplifying circuit proposed here uses only channel N MOSFETs controlled by a special circuit which eliminates the distortion and stability problems that occur with a non-complementary final step structure.

A certain power source voltage presupposes a specific output voltage for a specific charge impedance. Thus, with ± 150 VDC, theoretically 14000 W on 8Ω are obtained.

As the most innovative application of this amplifier pertains to power stages for 100 V. lines where the standard power is between 20 and 250 W., it is equipped with a power limiting circuit capable of adapting the power supplied to the requirements of the application.

This structure, aside from enabling the use of switching MOSFETs in high power audio amplifiers, enables the fabrication of 100 V. line amplifiers without the need for step-up transformers used by most of the manufacturers of this type of product.

The disadvantages of using step-up transformers are:
- Considerable weight and volume.
- The high cost of good transformers.
- High distortion at low frequencies - high output levels due to saturation of the magnetic nucleus.
- Deficient frequency response.
- System output of approximately 50%

While there are some commercial amplifiers which do not use step-up transformers, they are made using two separated amplifiers connected by a bridge. The main disadvantages of this type of system are:
- Complex amplifier because of floating output.
- Output of around 36%.
- Less reliable since there are two amplifiers rather than one.
- High cost.

All of these inconveniences are eliminated with the new amplification system.

The innovative device consists of an amplifying device as defined in claim 1.

The element in charge of correcting the differences between the input and output signals is a differential amplifier which uses two types of feedback: the first is basically to control the total circuit gain and the second to correct the alignments of the non-complementary output stages. This combination of feedback achieves global distortions comparable to those of amplifiers with complementary output stages.

The low level signal from the control element is amplified in voltage and is referenced to the high voltage charges by means of two level converters.

Since positive semicycle MOSFETs have a drain configuration and the negative semicycles MOSFETS have a common source configuration, a current mirror is used to properly excite the positive semicycle MOSFETs.

Current amplifiers are used to achieve the charging and discharging speeds of the input capacities of the final devices.

This considerably improves both distortion and the response to high frequencies.

The current amplifier for the positive semicylce is charged to a voltage slightly higher than that which charges the final stage. It is necessary to achieve the complete saturation of the final MOSFET device and optimise output and symmetrical reduction.

The output stage may be composed of more than one MOSFET in parallel if so required by the output power.

The maximum power is controlled by means of a high pass filter and an input signal compressor. For 100 V. line applications, the circuit controls the power supplied to the 100 V. line based on the desired maximum and the impedance charge associated therewith (see drawing). In high power applications it limits the power delivered to the charge based on the maximum supplied by the MOSFET, indispensable as a protective measure in the event of very low charge impedance or short-circuit.

In both cases, the input signal is reduced by a signal compressor. This also acts if the amplitude of the output signal exceeds the feed voltages (clip).

The temperature is controlled at two levels: at the first level, two circuits compensate, by means of a thermal sensor, the variations in the resting current of the final step based on the temperature. At the second level, a circuit analyses the evolution of the temperature over time. If the temperature rises rapidly, the level of the input signal is reduced to prevent the amplifier from overheating and shutting down.

### DESCRIPTION OF THE DRAWINGS

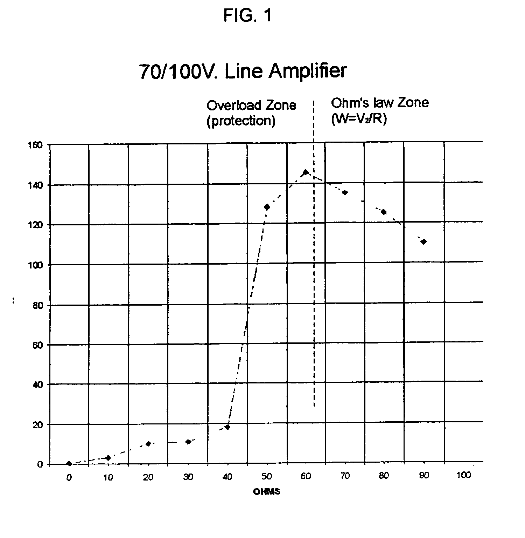

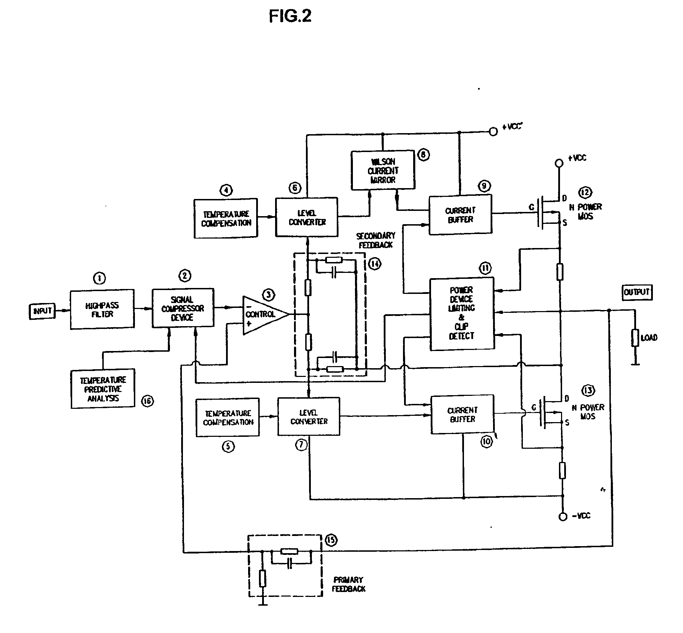

In order to illustrate what has been stated thus far, this descriptive report is accompanied by a page of drawings which is part of the report and which depicts the power supplied to a 100 V. line based on the desired maximum and the charge impedance associated therewith (figure 1) and a block diagram representing the essential parts of the circuits making up the new amplifier (2).

### DESCRIPTION OF A PRACTICAL CASE

The new amplifying unit works as follows:
First of all, there is a high pass filter (1) which acts together with a signal compressor (2). These circuits control the power supplied to the 100 V. line based on the desired maximum and the impedance charge associated therewith (see figure 1) while in high power applications it limits the power delivered to the charge based on the maximum supplied by the MOSFET, thereby preventing against very low charge impedance or short-circuit.

Following this, acting as a control element there is a differential amplifier (3) whose mission is to correct the differences between input and output signals using two types of feedback: the first (15) is basically to control the total circuit gain and the second (14) to correct the alignments of non-complementary output stages.

The low level signal from the control element (3) is amplified in voltage and is referenced to the high voltage charges by means of two level converters, one for positive semicycles (6) and another for negative semicycles (7).

After the positive cycle level converters (6), there is a current mirror (8) through which the configuration of the high voltage N channel switching MOSFETs for positive semicycles (12), organised in common drain configuration, unlike the negative semicycle MOSFETS (13) which are arranged in common source configuration, will be fed.

Current amplifiers (9, 10) are used to achieve the charging and discharging speeds of the input capacities of the final devices.

This considerably improves both distortion and the response to high frequencies.

The current amplifier for the positive semicylce (9) is powered to a voltage (+VCC) slightly higher than that which powers the final stage (+VCC). It is necessary to achieve the complete saturation of the final MOSFET device (12) and optimise output and symmetrical reduction.

The output stage (12, 13) may be composed of more than one MOSFET in parallel if so required by the output power.

In any event, there is a circuit (11) which controls the maximum power supplied to the charge depending on the signal compression circuit associated therewith (2) which reduces the input signal when the amplitude of the output signal exceeds the feed voltage.

As additional protective elements, there is a temperature management system which works at two different levels: at the first level, two circuits (4, 5) compensate by means of a thermal sensor the variations in the resting current of the final step based on the temperature. At the second level, a circuit analyses the evolution of the temperature over time. If the temperature rises rapidly, the level of the input signal is reduced to prevent the amplifier from overheating and shutting down

Having established the expressed concept, the list of claims follows, synthesising the innovations being claimed in this way.

## Claims

1. POWER STAGE of the type which uses switching MOSFETs specifically conceived for audio applications requiring elevated output voltages (100 Vrms) **characterised in that** it has non-complementary output stages formed by high voltage N channel switching MOSFETs, at least one (12) of said MOSFETs organised in a common drain configuration for amplifying positive semicycles of a signal and at least another one (13) of of said MOSFETs arranged in a common source configuration for amplifying negative semicycles of said signal, and further comprising:
- a high pass filter (1) which input is connected to an input signal (INPUT) and which output is connected to a signal compressor device (2) in order to act together to limit the output power to pre-determined values based on the required output voltage,
- a differential amplifier (3) with two inputs, one (-) of them connected to one output of said signal compressor (2), said differential amplifier (3) acting as a control element to correct differences between input (INPUT) and output (OUTPUT) signals,
• a first feedback circuit (15) to control the total gain, said first feedback circuit (15) being connected between the other (+) of said two inputs of the differential amplifier and an output of said output stages, which output is connected to a load (LOAD), and
• a second feedback circuit (14) to correct the alignments of said output stages, said second feedback circuit (14) being connected to an output of said differential amplifier and said output of the output stages
- two level converters (6, 7), one (6) for positive semicycles and another (7) for negative semicycles (7), both having inputs connected to respective outputs of said second feedback circuit (14)
- a current mirror circuit (8) having an input connected to an output of said level converter (6) for positive semicycles, to properly excite said at least one MOSFETs (12) for positive semicyclesand
- current amplifiers (9, 10), one (9) of them being connected between said current mirror (8) and said at least one MOSFETs (12) for positive semicycles an the other (10) being connected between said level converter (7) for negative semicycles and said at least one MOSFETs (13) for negative semicycles, to achieve the charging and discharging speeds of the input capacities of the MOSFETs, wherein said current amplifier (9) for positive semicycles is powered to a voltage (+VCC') slightly higher than that (+VCC) which powers the at least one MOSFETs (12) for positive semicycles.

2. POWER STAGE, according to the preceding claim, **characterised in that** the output stage (12, 13) is composed of more than one MOSFET in parallel.

3. POWER STAGE, according to any of the preceding claims, **characterised in that** it comprises a circuit (11) with inputs connected to a load (LOAD) and to the sources (S) of the MOSFETs (12, 13) and with outputs connected to said signal compressor (2) and said current amplifiers (9, 10), to control the maximum power supplied to the load (LOAD) wherein the signal compression device (2) reduces the input signal when the amplitude of the output signal exceeds the feed voltage(Vcc).

4. POWER STAGE, according to any of the preceding claims, **characterised in that** it comprises a temperature management system formed by:
- two temperature compensation circuits (4, 5) with respective outputs connected to said level converters (6, 7), to compensate by means of a thermal sensor the variations in the resting current of the final step (12, 13) based on the temperature, by acting on said level converters (6, 7), and
- a temperature predictive analysis circuit (16) connected to said signal compressor device (2), to analyse the evolution of temperature over time, and reduce the level of the input signal, by acting on said signal compressor device (2), to prevent the amplifier from overheating and shutting down, if it (16) predicts that temperature rises rapidly.

## Patentansprüche

1. LEISTUNGSSTUFE unter der Verwendung von Schalt-MOSFET, die besonders für Audio-Anwendungen entwickelt wurden, bei denen hohe Ausgangsspannungen (100 Vms) erforderlich sind, **dadurch gekennzeichnet, dass** sie nicht-ergänzende Ausgangsstufen umfasst, die aus Hochspannungs-MOSFET zur Schaltung des N-Kanals gebildet werden, wobei mindestens einer (12) dieser MOSFET in einer Drain-Konfiguration zur Verstärkung der positiven Halbzyklen eines Signals organisiert ist, und mindestens ein weiterer (13) dieser MOSFET in einer Konfiguration mit geteilter Quelle zur Verstärkung der negativen Halbzyklen dieses Signals angeordnet ist, und weiterhin folgende Elemente umfasst:
- einen Hochpassfilter (1), dessen Eingang an ein Eingangssignal (INPUT) und dessen Ausgang an ein Signalkomprimierungsgerät (2) angeschlossen ist, die zusammen die Ausgangsleistung auf vorbestimmte Werte bei der erforderlichen Ausgangsspannung begrenzen,
- einen Differenzverstärker (3) mit zwei Eingängen, wovon ein Eingang (-) am Ausgang des erwähnten Signalkomprimierers (2) angeschlossen wird, wobei dieser Differenzverstärker (3) als Steuerelement für den Ausgleich von Abweichungen zwischen den Eingangs- (INPUT) und Ausgangssignalen (OUTPUT) dient,
• einen ersten Rückkopplungskreis (15) zur Steuerung der Gesamtverstärkung, wobei dieser erste Rückkopplungskreis (15) zwischen dem anderen (+) der erwähnten beiden Eingänge des Differenzverstärkers und einem Ausgang der erwähnten Ausgangsstufen angeschlossen wird, dessen Ausgang an eine Last (LOAD) angeschlossen ist, und
• einen zweiten Rückkopplungskreis (14) zur Korrektur der Ausrichtung der erwähnten Ausgangsstufen, wobei der erwähnte zweite Rückkopplungskreis (14) an einen Ausgang des erwähnten Differenzverstärkers und den erwähnten Ausgang der Ausgangsstufen angeschlossen ist,
- zwei Pegelgleichrichtern (6, 7), einer (6) für positive Halbzyklen und der andere (7) für negative Halbzyklen (7), wobei die Eingänge beider an die entsprechenden Ausgänge des erwähnten zweiten Rückkopplungskreises (14) angeschlossen sind,
- einen Stromspiegelkreis (8), wo ein Eingang an einen Ausgang des erwähnten Pegelgleichrichters (6) für positive Halbzyklen angeschlossen ist, um zumindest einen der MOSFET (12) für positive Halbzyklen anzusteuern, und
- Stromverstärker (9, 10) wovon einer (9) zwischen den erwähnten Stromspiegel (8) und den erwähnten mindestens einen der MOSFET (12) für positive Halbzyklen angeschlossen ist, und der andere zwischen dem erwähnten Pegelgleichrichter (7) für negative Halbzyklen und mindestens einen der MOSFET (13) für negative Halbzyklen angeschlossen ist, um die Lade- und Entladegeschwindigkeiten der Eingangskapazitäten der MOSFET zu erreichen, wobei der erwähnte Stromverstärker (9) für positive Halbzyklen ein geringfügig höhere Spannung (+VDC') erhält als die Spannung (+VDC), die mindestens einer der MOSFET (12) für positive Halbzyklen erhält.

2. LEISTUNGSSTUFE gemäß dem vorstehenden Patentanspruch, **dadurch gekennzeichnet, dass** die Ausgangsstufe (12, 13) aus mehr als einem und parallel geschalteten MOSFET besteht.

3. LEISTUNGSSTUFE gemäß einem der vorstehenden Patentansprüche, **dadurch gekennzeichnet, dass** sie einen Stromkreis (11) aufweist, dessen Eingänge an eine Last (LOAD) und an die Quellen (S) der MOSFET (12, 13) angeschlossen sind, und dessen Ausgänge an den erwähnten Signalkomprimierer (2) und an die erwähnten Stromverstärker (9, 10) angeschlossen sind, um die maximale Leistung zu kontrollieren, die an die Last (LOAD) geliefert wird, wobei das Signalkomprimierungsgerät (2) das Eingangssignal verringert, sobald die Amplitude des Ausgangssignals die Versorgungsspannung (VDC) überschreitet.

4. LEISTUNGSSTUFE gemäß einem der vorstehenden Patentansprüche, **dadurch gekennzeichnet, dass** sie ein Temperatursteuersystem aufweist, das aus den folgenden Elementen besteht:
- zwei Temperaturausgleichskreise (4, 5) deren entsprechende Ausgänge an die erwähnten Pegelgleichrichter (6, 7) angeschlossen sind, um die Variationen im Reststrom in der Endstufe (12, 13) anhand eines Temperatursensors beruhend auf der Temperatur auszugleichen, indem sie auf die erwähnten Pegelgleichrichter (6,7) wirken, und
- einem Analysekreis zur Vorhersehung der Temperatur (16), der an das Signalkomprimierungsgerät (2) angeschlossen ist, um die Entwicklung der Temperatur über die Zeit zu verfolgen, und den Pegel des Eingangssignals zu verringern, indem auf das erwähnte Signalkomprimierungsgerät eingewirkt wird, um eine Überhitzung und Abschaltung des Verstärkers zu vermeiden, wenn er (16) vorhersieht, dass die Temperatur schnell ansteigt.

## Revendications

1. ÉTAGE DE PUISSANCE du genre utilisant des TECMOS de commutation spécifiquement conçus pour des applications d'audio nécessitant des tensions de sortie hautes (100 Vm) **caractérisé en ce qu'**il comporte des étages de sortie non complémentaires formés par des TECMOS de commutation de direction N à tension haute, au moins un (12) de ces TECMOS étant aménagé dans une configuration de drain commun pour amplifier les semi-cycles positifs d'un signal et au moins un autre (13) de ces TECMOS étant aménagé dans une configuration de source commune pour amplifier les semi-cycles négatifs de ce signal et comprenant de plus:
- un filtre passe-haut (1) dont l'entrée est reliée à un signal d'entrée (INPUT) et dont la sortie es reliée à un dispositif de compression des signaux (2) pour opérer ensemble afin de limiter la puissance de sortie à des valeurs prédéterminées basées sur la tension de sortie requise,
- un amplificateur différentiel (3) ayant deux entrées, dont une (-) est reliée à une sortie de ce compresseur des signaux (2), cet amplificateur différentiel (3) agissant en tant qu'élément de contrôle pour corriger les différences entre signaux d'entrée (INPUT) et de sortie (OUTPUT),
- un premier circuit de retour (15) pour contrôler le gain total, ce circuit de retour (15) étant relié entre l'autre (+) de ces deux entrées de l'amplificateur différentiel et une sortie de ces étages de sortie, cette sortie étant reliée à une charge (LOAD), et
- un deuxième circuit de retour (14) pour corriger les alignements de ces étages de sortie, ce deuxième circuit de retour (14) étant relié à une sortie de cet amplificateur différentiel et cette sortie des étages de sortie.
- deux convertisseurs des niveaux (6, 7), l'un (6) pour les semi-cycles positifs et l'autre (7) pour des semi-cycles négatifs (7) ayant tous les deux des entrées reliées à des sorties respectives de ce deuxième circuit de retour (14).
- un circuit miroir de courant (8) ayant une entrée reliée à une sortie de ce convertisseur de niveaux (6) pour des semi-cycles positifs, pour exciter de façon appropriée cet au moins un TECMOS (12) pour semi-cycles positifs, et
- des amplificateurs de courant (9, 10), l'un (9) étant relié entre ce réflecteur de courant (8) et cet au moins un TECMOS (12) pour semi-cycles positifs et l'autre (10) étant relié entre ce convertisseur de niveaux (7) pour des semi-cycles négatifs et cet au moins un TECMOS (13) pour semi-cycles négatifs, pour obtenir les vitesses de chargement et de déchargement des capacités d'entrée du TECMOS, dans lequel cet amplificateur de courant (9) pour des semi-cycles positifs est alimenté à une tension (+VCC') légèrement supérieure à celle (+VCC) qui alimente cet au moins un TECMOS (12) pour les semi-cycles positifs.

2. ÉTAGE DE PUISSANCE, conformément à la revendication précédente, **caractérisé en ce que** l'étage de sortie (12, 13) comporte plus d'un TECMOS en parallèle.

3. ÉTAGE DE PUISSANCE, conformément à une quelconque des revendications précédentes, **caractérisé en ce qu'**il comporte un circuit (11) ayant des entrées reliées à une charge (LOAD) et à des sources (S) des TECMOS (12, 13) et des sorties reliées à ce compresseur des signaux (2) et cet amplificateur de courant (9, 10) pour contrôler la puissance maximale alimentée à la charge (LOAD), dans lequel le dispositif de compression des signaux (2) réduit le signal d'entrée lorsque l'amplitude du signal de sortie est supérieure à la tension d'alimentation (Vcc).

4. ÉTAGE DE PUISSANCE, conformément à une quelconque des revendications précédentes, **caractérisé en ce qu'**il comporte un système de gestion de la température formé par:
- deux circuits de compensation de température (4, 5) ayant des sorties respectives reliées à ces convertisseurs de niveaux (6, 7) pour compenser au moyen d'un capteur de chaleur les variations du courant restant à l'étape finale (12, 13) basé sur la température, en agissant sur ces convertisseurs de niveaux (6, 7), et
- un circuit d'analyse de prédiction de température (16) relié à ce dispositif de compression des signaux (2) pour analyser l'évolution de la température dans le temps et réduire le niveau du signal d'entrée, en agissant sur ce dispositif de compression des signaux (2), pour éviter que l'amplificateur se surchauffe et s'éteigne, s'il (16) prédit que la température monte vite.
